# EUROPEAN PATENT SPECIFICATION

(11) **EP 4 350 367 B1**
(45) Date of publication and mention of the grant of the patent: **25.03.2026**
(21) Application number: 22810284.4
(22) Date of filing: 25.04.2022
(51) Int. Cl.: G01R 31/12, G01R 1/04, G01R 31/16, G01R 31/58

(54) **INSULATION WITHSTAND VOLTAGE DETECTION METHOD AND DETECTION DEVICE FOR WIRING HARNESS, AND AUTOMOBILE WIRING HARNESS ASSEMBLY LINE**
VERFAHREN ZUR ERKENNUNG EINER ISOLATIONSWIDERSTANDSSPANNUNG UND ERKENNUNGSVORRICHTUNG FÜR EINEN KABELBAUM UND MONTAGELINIE FÜR EINEN AUTOMOBILKABELBAUM
PROCÉDÉ DE DÉTECTION DE TENSION DE TENUE D'ISOLATION ET DISPOSITIF DE DÉTECTION POUR FAISCEAU DE CÂBLES, ET CHAÎNE DE MONTAGE DE FAISCEAU DE CÂBLES AUTOMOBILE

(30) Priority: 25.05.2021 CN 202110573662
(43) Date of publication of application: 10.04.2024
(73) Proprietor: Changchun Jetty Automotive Technology Co., Ltd., Changchun, Jilin 130000 (CN)
(72) Inventor: WANG, Chao, Changchun, Jilin 130000 (CN)
(74) Representative: Boult Wade Tennant LLP
(86) International application number: PCT/CN2022/088973
(87) International publication number: WO 2022/247551

(56) References cited:
- WO-A1-2021/019400
- CN-A- 103 809 085
- CN-A- 103 809 085
- CN-A- 112 557 847
- CN-A- 113 325 278
- CN-U- 205 982 528
- CN-U- 207 752 102
- JP-A- 2000 310 661
- US-B1- 6 518 772

## Description

### RELATED APPLICATION

This application claims priority to Chinese Patent Application No. 202110573662.8, filed May 25, 2021, entitled 'insulation withstand voltage detection method and detection method for a wiring harness, and automobile wiring harness assembly line' .

### TECHNICAL FIELD

The present disclosure relates to the technical field of automobile manufacturing, and particularly to an insulation withstand voltage detection method and detection method for a wiring harness, and an automobile wiring harness assembly line.

### BACKGROUND

Electric vehicles need to use a lot of high-voltage wiring harnesses, which require a high safety and should pass the dielectric insulation detection.

At present, the dielectric insulation detection of the high-voltage wiring harness is mainly carried out in a laboratory. Usually, a conductive liquid medium is used as the detection conductive medium, or an external grounding copper mesh is made to play the role of an electrode plate when the insulation layer of the wiring harness is broken down. Those detection methods require a high test voltage, which is poor in safety and takes a long time, and samples for detection should also be prepared, so it is impossible to realize the in-line detection of finished products, and the sample preparation is difficult.

An insulation withstand voltage detection apparatus and detection method are known in the prior art, e.g. WO 2021/019400 A1.

### SUMMARY

An objective of the present disclosure is to provide an insulation withstand voltage detection method and detection device for a wiring harness, and an automobile wiring harness assembly line, so as to alleviate the technical problem in the prior art that the dielectric insulation detection of a high-voltage wiring harness cannot realize the in-line detection of finished products.

The above objective of the present disclosure can be achieved by adopting the technical solutions which are defined in independent claims 1 and 5.

The present disclosure provides an automobile wiring harness assembly line, including the insulation withstand voltage detection device for the wiring harness as described above.

The present disclosure has the following characteristics and advantages:
According to the insulation withstand voltage detection method for the wiring harness, the air pressure in the enclosed cavity is reduced, so that a set vacuum degree is reached inside the enclosed cavity. According to Paschen's law and Townsend's discharge theory, when a high voltage applied between the electrodes under a certain vacuum degree reaches a certain level, gas ionization and conduction may occur, thereby realizing a glow discharge. This principle is utilized by the insulation withstand voltage detection method for the wiring harness, in which the power supply applies a test voltage between the to-be-detected wiring harness and the conductive electrode plate under a set vacuum degree, and the conductive electrode plate and the conductor of the to-be-detected wiring harness can form electrodes referred to in Paschen's Law. If the external insulation layer of the to-be-detected wiring harness is not broken, no breakdown will occur, and if the external insulation layer is broken, current breakdown will occur. By capturing and detecting the voltage or the leakage current, it may be judged whether a breakdown occurs, so as to determine whether the external insulation layer of the to-be-detected wiring harness is good, and whether the dielectric insulation and the insulation withstand voltage performance meet the requirements.

By adopting Paschen's law and Townsend's discharge theory, the insulation withstand voltage detection method can use a low test voltage to detect the insulation withstand voltage performance of the to-be-detected wiring harness at a high voltage, thereby reducing the test voltage and realizing the nondestructive detection. The insulation withstand voltage detection method may detect a single wiring harness or wiring harnesses connected to electrical components, thereby realizing the detection of the finished wiring harness in actual delivery state. The insulation withstand voltage detection method takes short detection time and realizes a rapid detection. Moreover, the to-be-detected wiring harness is located in the enclosed cavity, and the discharge phenomenon also occurs in the enclosed cavity, thereby realizing an enclose test with high safety. Therefore, during the assembly and production process of the wiring harness, the insulation withstand voltage detection method may be adopted to detect the wiring harness to realize in-line detection of the finished wiring harnesses, which is beneficial to improving the detection efficiency and the production efficiency.

### BRIEF DESCRIPTION OF THE DRAWINGS

The following drawings are only for the schematic illustration and explanation of the present disclosure, rather than limiting the scope of the present disclosure. In the drawings,
FIGS. 1 and 2 are schematic structural diagrams of an insulation withstand voltage detection device for a wiring harness provided by the present disclosure;
FIG. 3 is a schematic structural diagram of a conductive module in an insulation withstand voltage detection device for a wiring harness provided by the present disclosure;
FIG. 4 is a schematic structural diagram of an insulation enclosing module in an insulation withstand voltage detection device for a wiring harness provided by the present disclosure;
FIG. 5 is a connection schematic diagram of a to-be-detected wiring harness in an insulation withstand voltage detection method for a wiring harness provided by the present disclosure; and
FIG. 6 is a schematic diagram of an insulation withstand voltage detection method for a wiring harness provided by the present disclosure.

### DESCRIPTION OF EMBODIMENTS

For a clearer understanding of the technical features, the objectives and the effects of the present disclosure, specific embodiments of the present disclosure will now be described with reference to the drawings. In the description of the present disclosure, 'a plurality of' means two or more unless otherwise specified.

### Embodiment 1

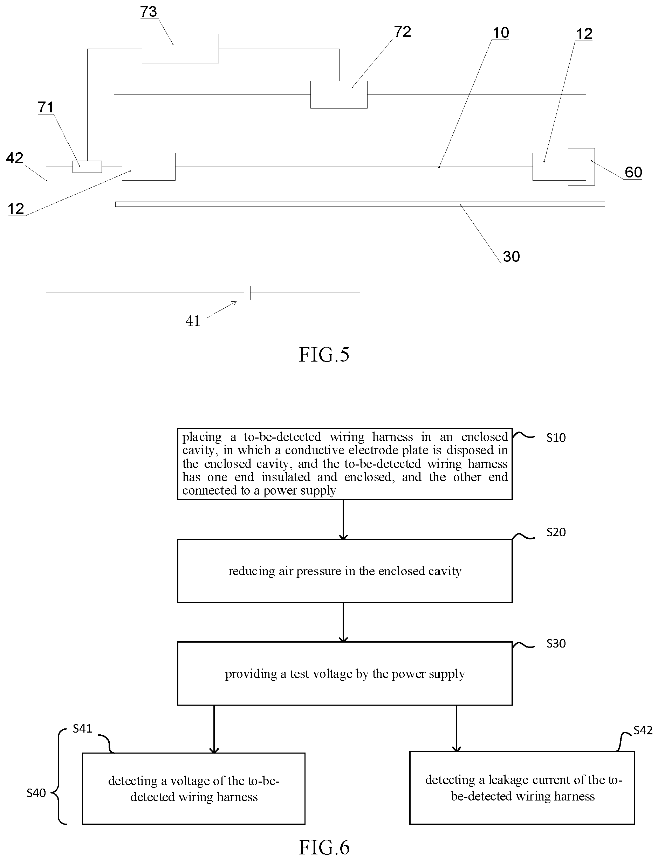

The present disclosure provides an insulation withstand voltage detection method for a wiring harness as illustrated in FIG. 6, which includes: step S10, placing a to-be-detected wiring harness 10 in an enclosed cavity 21, in which a conductive electrode plate 30 is disposed in the enclosed cavity 21, and the to-be-detected wiring harness 10 has one end insulated and enclosed, and the other end connected to a power supply 41; step S20, reducing air pressure in the enclosed cavity 21; step S30, providing a test voltage by the power supply 41; step S40, detecting a voltage of the to-be-detected wiring harness 10, and/or detecting a leakage current of the to-be-detected wiring harness 10.

According to the insulation withstand voltage detection method for the wiring harness, the air pressure in the enclosed cavity 21 is reduced, so that a set vacuum degree is reached inside the enclosed cavity 21. According to Paschen's law and Townsend's discharge theory, when a high voltage applied between the electrodes under a certain vacuum degree reaches a certain level, gas ionization and conduction may occur, thereby realizing a glow discharge. This principle is utilized by the insulation withstand voltage detection method for the wiring harness, in which the power supply 41 applies a test voltage between the to-be-detected wiring harness 10 and the conductive electrode plate 30 under a set vacuum degree, and the conductive electrode plate 30 and the conductor of the to-be-detected wiring harness 10 can form electrodes referred to in Paschen's Law. If the external insulation layer of the to-be-detected wiring harness 10 is not broken, no breakdown will occur, and if the external insulation layer is broken, current breakdown will occur. By capturing and detecting the voltage or the leakage current, it may be judged whether a breakdown occurs, so as to determine whether the external insulation layer of the to-be-detected wiring harness 10 is good, and whether the dielectric insulation and the insulation withstand voltage performance meet the requirements. The conductive electrode plate 30 may be grounded or electrically connected to the power supply 41.

By adopting Paschen's law and Townsend's discharge theory, the insulation withstand voltage detection method can use a low test voltage to detect the insulation withstand voltage performance of the to-be-detected wiring harness 10 at a high voltage, thereby reducing the test voltage and realizing the nondestructive detection. The insulation withstand voltage detection method may detect a single wiring harness or wiring harnesses connected to electrical components, thereby realizing the detection of the finished wiring harness in actual delivery state. The insulation withstand voltage detection method takes short detection time and realizes a rapid detection. Moreover, the to-be-detected wiring harness 10 is located in the enclosed cavity 21, and the discharge phenomenon also occurs in the enclosed cavity 21, thereby realizing an enclose test with high safety. Therefore, during the assembly and production process of the wiring harness, the insulation withstand voltage detection method may be adopted to detect the wiring harness to realize in-line detection of the finished wiring harnesses, which is beneficial to improving the detection efficiency and the production efficiency.

In the insulation withstand voltage detection method, the entire to-be-detected wiring harness 10 is placed in the enclosed cavity 21 for an enclose test. The wiring harness connected to electrical components may be detected, thereby realizing the detection of the finished wiring harness in actual delivery state. For example, a clip or a bracket is connected to the finished wiring harness, in which case the clip or the bracket may be placed in the enclosed cavity 21 together with the finished wiring harness for detection. By adopting the insulation withstand voltage detection method, the comprehensive detection takt of the insulation withstand voltage detection of the to-be-detected wiring harness 10 may be controlled within 2 minutes. The insulation withstand voltage detection method realizes a safe, rapid and nondestructive detection, and can perform an in-line detection of the insulation withstand voltage performance of the finished wiring harness and the accessory protection device in delivery state.

Further, in step S20, the air pressure in the enclosed cavity 21 is reduced. The test voltage as well as the air pressure and the vacuum degree in the enclosed cavity 21 are set according to Paschen's law, so that the test voltage is one third of the voltage in the normal high-voltage test. The test voltage of the general detection device needs to reach 3,000 V to 5,000 V. Exemplarily, the air pressure in the enclosed cavity 21 is decreased to a vacuum degree of 0 mbar to 5,000 mbar, and the test voltage of the insulation withstand voltage detection method for the wiring harness may be 1,000 V to 1,500 V.

The test voltage provided by the power supply 41 may be a DC voltage or an AC voltage. Step S40 includes: step S41, detecting the voltage of the to-be-detected wiring harness 10, and step S42, detecting the leakage current of the to-be-detected wiring harness 10. Step S41 and step S42 may be performed alternatively or both. In some cases, it is possible to judge whether the discharge phenomenon occurs based on the voltage of the to-be-detected wiring harness 10. In other cases, it is possible to judge whether the discharge phenomenon occurs by detecting the current passing through the to-be-detected wiring harness 10. Exemplarily, both the current passing through the to-be-detected wiring harness 10 and the voltage of the to-be-detected wiring harness 10 are detected, thereby more accurately judging whether the discharge phenomenon occurs. A detection value of the voltage is compared with a set requirement value of the voltage, a detection value of the leakage current is compared with a set requirement value of the leakage current, and when the detection value of the voltage and the detection value of the leakage current both meet requirements, it is judged that the insulation withstand voltage performance of the to-be-detected wiring harness 10 is qualified.

### Embodiment 2

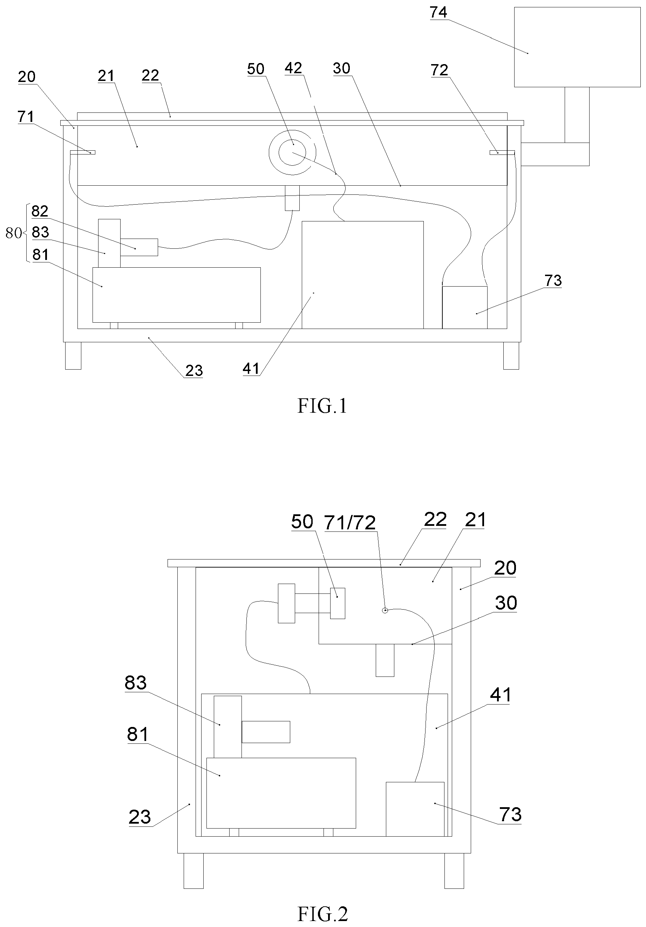

The present disclosure provides insulation withstand voltage detection device for a wiring harness as illustrated in FIGS. 1 and 2, which includes a detection chamber 20, a vacuum device 80, a power supply 41 and a conductive module 50. The detection chamber 20 is provided with an enclosed cavity 21 in which a conductive electrode plate 30 is disposed. The vacuum device 80 is communicated with the enclosed cavity 21. A first end of the conductive module 50 is electrically connected to the power supply 41. A second end of the conductive module 50 is connected to a to-be-detected wiring harness 10 and located in the enclosed cavity 21. The insulation withstand voltage detection device further includes at least one selected from the group consisting of a current detection sensor 71 and a voltage detection sensor 72. The current detection sensor 71 is connected in series between the power supply 41 and the conductive module 50. The voltage detection sensor 72 is connected in parallel to the to-be-detected wiring harness 10.

The to-be-detected wiring harness 10 is placed in the enclosed cavity 21, with one end connected to the conductive module 50; the vacuum device 80 reduces the air pressure in the enclosed cavity 21, so that a set vacuum degree is reached inside the enclosed cavity 21; the to-be-detected wiring harness 10 is connected to the power supply 41 through the conductive module 50, and the power supply 41 applies a test voltage between the conductive electrode plate 30 and the to-be-detected wiring harness 10.

According to Paschen's law and Townsend's discharge theory, when a high voltage applied between the electrodes under a certain vacuum degree reaches a certain level, gas ionization and conduction may occur, thereby realizing a glow discharge. With this principle, under a set vacuum degree, the power supply 41 applies a test voltage between the to-be-detected wiring harness 10 and the conductive electrode plate 30, and the conductive electrode plate 30 and the conductor in the to-be-detected wiring harness 10 can form electrodes referred to in Paschen's Law. If the external insulation layer of the to-be-detected wiring harness 10 is not broken, no breakdown will occur, and if the external insulation layer is broken, there will be a current breakdown. By capturing and detecting the voltage by the current detection sensor 71 or capturing and detecting the leakage current by the voltage detection sensor 72, it can be judged whether a breakdown occurs, so as to determine whether the external insulation layer of the to-be-detected wiring harness 10 is intact, and whether the dielectric insulation and the insulation withstand voltage performance meet the requirements. The conductive electrode plate 30 may be grounded or electrically connected to the power supply 41.

By adopting Paschen's law and Townsend's discharge theory, the insulation withstand voltage detection device can use a low test voltage to detect the insulation withstand voltage performance of the to-be-detected wiring harness 10 at a high voltage, thereby reducing the test voltage and realizing the nondestructive detection. The insulation withstand voltage detection device can detect only a single wiring harness, or a wiring harness connected to electrical components, thereby realizing the detection of the finished wiring harness in actual delivery state. The insulation withstand voltage detection device has a fast detection speed and shortened detection time, thereby realizing a rapid detection. Moreover, the to-be-detected wiring harness 10 is located in the enclosed cavity 21, and the discharge phenomenon also occurs in the enclosed cavity 21, thereby realizing an enclose test with high safety. Therefore, by disposing the insulation withstand voltage detection device in the wiring harness assembly and production line, it is possible to realize the detection of the wiring harness and the in-line detection of the finished wiring harness, thereby ensuring that the detection takt is coordinated with the anteroposterior devices, which is beneficial to improving the detection efficiency and the production efficiency.

Based on Paschen's law, by setting the proper air pressure and test voltage in the enclosed cavity 21, the present disclosure can reduce the test voltage to less than one third of the applied voltage in a general test device, thereby improving the safety and realizing nondestructive detection. The wiring harness mounted with products such as clips or brackets can also be subjected to the insulation withstand voltage detection. The insulation withstand voltage detection device may be mounted in the production line, so as to realize the in-line detection of the product one-piece flow and ensure the insulation safety and reliability of the high-voltage wiring harness. The test voltage of the general test device should reach 3,000 V to 5,000 V. Exemplarily, the air pressure in the enclosed cavity 21 is decreased to have a vacuum degree of 0 mbar to 5,000 mbar, and the test voltage in the insulation withstand voltage detection method of the wiring harness may be 1,000 V to 1,500 V.

The insulation withstand voltage detection device includes a stage frame 23, which includes a base on which the detection chamber 20 and the vacuum device 80 are fixed. the detection chamber 20 is at the top and is surrounded by an insulating protective cover. A grating protector is provided in the detection chamber 20 and is close to a position where the to-be-detected wiring harness 10 is placed, so as to protect the manual operation of placing the to-be-detected wiring harness 10. The enclosed cavity 21 may be opened and closed to facilitate putting in and taking out the to-be-detected wiring harness 10. Specifically, the detection chamber 20 includes an upper cover 22 and a sealing strip. The upper cover 22 is connected to a shell of the detection chamber 20 by a hinge, and the sealing strip is located at a joint of the upper cover 22, so as to ensure that the enclosed cavity 21 is in a sealed state when the upper cover 22 is enclosed.

The vacuum device 80 includes a vacuum pump 81, which is communicated with the enclosed cavity 21 to vacuumize the enclosed cavity 21. Specifically, the vacuum device 80 is connected to the enclosed cavity 21 through a vacuum tube 82, one end of which is communicated with the enclosed cavity 21, and the other end of which is connected to the vacuum pump 81. Further, the vacuum device 80 includes a control system 83 configured to detect the air pressure in the enclosed cavity 21, and adjust the air pressure to a requirement value by controlling the vacuum pump 81 to work.

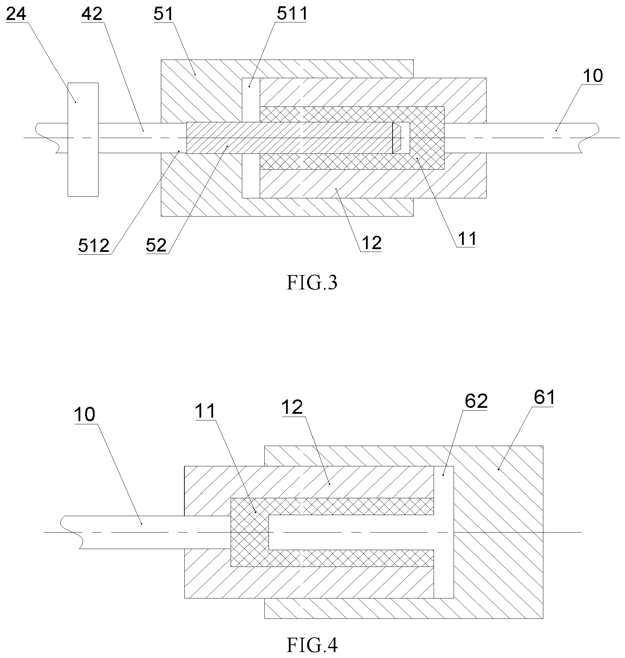

According to the invention, the conductive module 50 includes a first insulation docking shell 51 and a conductive core 52 disposed therein. The first insulation docking shell 51 is configured to accommodate an end of the to-be-detected wiring harness 10, and the conductive core 52 is in contact with a conductive terminal 11 of the to-be-detected wiring harness 10. As illustrated in FIG. 3, the first insulation docking shell 51 fits and fixes the end of the to-be-detected wiring harness 10, and the power supply 41 is electrically connected to the conductive terminal 11 of the to-be-detected wiring harness 10 through the conductive core 52. Advantageously, on the one hand, the sealability between the end of the to-be-detected wiring harness 10 and the enclosed cavity 21 is ensured, and the discharge at the end of the to-be-detected wiring harness 10 is reduced, so as to accurately measure the insulation withstand voltage performance of the insulation layer of the to-be-detected wiring harness 10; on the other hand, the to-be-detected wiring harness 10 can be conveniently mounted and dismounted, which is beneficial to improving the in-line detection efficiency and ensuring the coordination between the detection takt and the production takt.

Further, the first insulation docking shell 51 is provided with an accommodation cavity 511 and a shell through hole 512 disposed on a bottom wall of the accommodation cavity 511. The accommodation cavity 511 is configured to accommodate the end of the to-be-detected wiring harness 10. The conductive core 52 is inserted into the shell through hole 512 and at least partially extends into the accommodation cavity 511. A power cable 42 has one end passing through the shell through hole 512 and connected to the conductive core 52, and the other end connected to the power supply 41. As illustrated in FIG. 3, an inner wall of the accommodation cavity 511 is fitted with a sidewall of the end of the to-be-detected wiring harness 10, so that the end of the to-be-detected wiring harness 10 is fixed in the accommodation cavity 511 by a resistance generated therebetween by mutual pressing of the two, which facilitates the disassembly and assembly of the to-be-detected wiring harness 10 and the first insulation docking shell 51, increases the detection efficiency, and improves the sealability between the end of the to-be-detected wiring harness 10 and the enclosed cavity 21, thereby avoiding the discharge at the end of the to-be-detected wiring harness 10. In an embodiment, the end of the to-be-detected wiring harness 10 is provided with a wiring harness insulation shell 12, which sleeves the end of the to-be-detected wiring harness 10 and wraps around the conductive terminal 11. As illustrated in FIG. 3, the end of the to-be-detected wiring harness 10 is fixed in the accommodation cavity 511 through the fitting between the sidewall of the wiring harness insulation shell 12 and the inner wall of the accommodation cavity 511, thereby further improving the insulation and sealing effect.

The power cable 42 passes through the sidewall of the detection chamber 20, and the conductive core 52 is connected to the power supply 41 through the power cable. In an embodiment, the power cable is connected to a sealing member 24, the first insulation docking shell 51 is disposed inside the sidewall of the detection chamber 20, the sealing member 24 is connected to the outer side of the sidewall of the detection chamber 20, and the sealing member 24 seals the hole of the sidewall of the detection chamber 20 where the power cable 42 passes through. Specifically, the sealing member 24 includes a cover plate and a sealing ring, the cover plate is fixed to the outer side of the sidewall of the detection chamber 20 by screws, and the sealing ring is disposed between the cover plate and the sidewall of the detection chamber 20.

According to the invention, the insulation withstand voltage detection device further includes an insulation enclosing module 60. In some cases, both ends of the to-be-detected wiring harness 10 are exposed, one of which is connected to the conductive module 50, and the other is insulated and enclosed by the insulation enclosing module 60. The insulation enclosing module 60 can prevent a discharge at the end of the to-be-detected wiring harness 10, so as to more accurately measure the insulation withstand voltage performance of the insulation layer of the to-be-detected wiring harness 10.

Further, the insulation enclosing module 60 includes a second insulation docking shell 61 configured to accommodate an end of the to-be-detected wiring harness 10 which can be plugged with the second insulation docking shell 61. As illustrated in FIG. 4, the second insulation docking shell 61 is provided with a blind hole 62 into which the end of the to-be-detected wiring harness 10 extends, and a sidewall of the end of the to-be-detected wiring harness 10 is fitted with an inner wall of the blind hole 62, so as to realize a fixation of the second insulation docking shell 61 and the end of the to-be-detected wiring harness 10, and realize enclosing the conductive terminal 11 of the to-be-detected wiring harness 10, thereby ensuring the sealing and insulation effect, avoiding the discharge at the end of the to-be-detected wiring harness 10, facilitating the disassembly and assembly, and improving the in-line detection efficiency. In an embodiment, the end of the to-be-detected wiring harness 10 is provided with a wiring harness insulation shell 12, which sleeves the end of the to-be-detected wiring harness 10 and encloses the conductive terminal 11. As illustrated in FIG. 4, the end of the to-be-detected wiring harness is fixed in the blind hole 62 through the fitting between the sidewall of the wiring harness insulation shell 12 and the inner wall of the blind hole 62, thereby further improving the insulation and sealing effect.

The test voltage is transmitted to the conductive module 50 through the power cable 42. The performances of the insulation withstand voltages of the insulation layer of the power cable 42, the first insulation docking shell 51 and the second insulation docking shell 61 are all higher than the designed insulation withstand voltage performance of the to-be-detected wiring harness 10. The conductive module 50 and the insulation enclosing module 60 can be disassembled and replaced to adapt to various wiring harnesses.

The conductive electrode plate 30 is disposed in the enclosed cavity 21, and a small distance is maintained between the conductive electrode plate 30 and the to-be-detected wiring harness 10. The conductive electrode plate 30 may be disposed on the bottom wall, the top or the sidewall of the enclosed cavity 21. The area of the conductive electrode plate 30 is larger than a projection area of the to-be-detected wiring harness 10 mounted in the enclosed cavity 21. Further, the conductive electrode plate 30 is disposed on a bottom wall of the detection chamber 20, and the to-be-detected wiring harness 10 may be placed on the conductive electrode plate 30. In some embodiments, the conductive electrode plate 30 is an independent plate structure mounted on the bottom wall of the detection chamber 20. In other embodiments, the inner side of the bottom wall of the detection chamber 20 is made of a conductive material, and the bottom wall of the detection chamber 20 serves as the conductive electrode plate 30.

The insulation withstand voltage detection device includes a detection system, which includes a software and hardware system 73 and a display system 74. As illustrated in FIG. 5, both the current detection sensor 71 and the voltage detection sensor 72 are connected to the software and hardware system 73, so that the voltage and the leakage current can be extracted in real time. The software and hardware system 73 makes a judgement by comparing the detection values of the voltage and the leakage current with the set requirement values, and displays the result of the judgment on a display screen of the display system 74. Further, the software and hardware system 73 displays the process and the result of the judgment on the display screen, and marks the qualified high-voltage wiring harness.

When the insulation withstand voltage detection device is used, the to-be-detected wiring harness 10 is placed in a vacuum environment, the conductive electrode plate 30 and the conductor of the to-be-detected wiring harness 10 can form electrodes referred to in Paschen's Law, and a test voltage is applied to the to-be-detected wiring harness 10, so as to detect the voltage breakdown resistance of the insulation layer of the to-be-detected wiring harness 10. The voltage contrast value and the leakage current value of the to-be-detected wiring harness 10 are detected by the current detection sensor 71 and the voltage detection sensor 72, and then the results are judged. The voltage contrast value and the leakage current value of the to-be-detected wiring harness 10 are collected, thereby providing indicators for the quantitative real-time monitoring of the insulation withstand voltage of the to-be-detected wiring harness 10. The detection value is compared with the set requirement value for judgement, and the judgment result is output on the display screen, which is convenient for non-professionals to acquire the detection result and make corresponding treatment.

The insulation layer of the wiring harness has an insulation resistance, which is usually greater than 100 MΩ. When the broken insulation layer of the wiring harness is instantly broken down, the insulation resistance will drop instantly. In an embodiment, the insulation withstand voltage detection device includes a resistance measuring instrument, which is connected to the conductor of the to-be-detected wiring harness 10 and the surface of the insulation layer of the to-be-detected wiring harness 10, and can measure the decrease of the insulation resistance when the insulation layer is breakdown. If the resistance measuring instrument detects a signal indicating that the insulation resistance drops, it means that the insulation layer of the wiring harness has been broken down.

### Embodiment 3

The present disclosure provides an automobile wiring harness assembly line, which includes the insulation withstand voltage detection device of the wiring harness. In the automobile wiring harness assembly line, through the insulation withstand voltage detection device, it is possible to use a low test voltage to detect the insulation withstand voltage performance of the to-be-detected wiring harness 10 at a high voltage, thereby reducing the test voltage and realizing the nondestructive detection. It is possible to detect the wiring harnesses connected to electrical components, thereby realizing the detection of the finished wiring harness in actual delivery state. Moreover, the detection time is short, realizing rapid detection. By disposing the insulation withstand voltage detection device in the automobile wiring harness assembly line, it is possible to detect the wiring harness using the insulation withstand voltage detection device during the assembly and production of the wiring harness, so as to realize the in-line detection of the finished wiring harness, and ensure the coordination between the detection takt and the production takt of the anteroposterior devices, which is beneficial to improving the detection efficiency and the production efficiency. It is also possible to realize the in-line detection of the product one-piece flow and ensure the insulation safety and reliability of the high-voltage wiring harness.

Those described are illustrative specific embodiments of the present disclosure, rather than limiting the scope of the present disclosure.

## Claims

1. An insulation withstand voltage detection device for a wiring harness, comprising:
a detection chamber (20) provided with an enclosed cavity (21) in which a conductive electrode plate (30) is disposed;
a vacuum device (80) communicated with the enclosed cavity (21);
a power supply (41) electrically connected to the conductive electrode plate (30);
a conductive module (50), a first end of which is electrically connected to the power supply (41), and a second end of which is connected to a to-be-detected wiring harness (10) and located in the enclosed cavity (21); and
a current detection sensor (71) and/or a voltage detection sensor (72), wherein the current detection (71) sensor is connected in series between the power supply (41) and the conductive module (50), and the voltage detection sensor (72) is used to be connected in parallel to the to-be-detected wiring harness (10);
wherein the conductive module(50) comprises a first insulation docking shell(51) and a conductive core(52) disposed therein; and the first insulation docking shell(51) is configured to accommodate an end of the to-be-detected wiring harness (10), and the conductive core (52) is in contact with a conductive terminal(11) of the to-be-detected wiring harness(10);
wherein the first insulation docking shell (51) is provided with an accommodation cavity(511), and a shell through hole(512) disposed on a bottom wall of the accommodation cavity(511);
the accommodation cavity (511) is configured to accommodate the end of the to-be-detected wiring harness(10), and the conductive core(52) is inserted into the shell through hole(512) and at least partially extends into the accommodation cavity(511); and
**characterized in that**, an inner wall of the accommodation cavity (511) is fitted with a sidewall of one end of the to-be-detected wiring harness (10), and the end of the to-be-detected wiring harness (10) is fixed in the accommodation cavity (511) by a resistance generated by mutual pressing between the inner wall of the accommodation cavity (511) and the end of the to-be-detected wiring harness (10); and
the device further comprises an insulation enclosing module (60) configured to insulate and enclose the other end of the to-be-detected wiring harness (10).

2. The insulation withstand voltage detection device for the wiring harness according to claim 1, wherein the conductive core(52) is connected to the power supply(41) through a power cable(42), a sealing member(24) is connected to the power cable(42), the first insulation docking shell(51) is disposed inside a sidewall of the detection chamber(20), and the sealing member(24) is connected to an outer side of the sidewall of the detection chamber(20).

3. The insulation withstand voltage detection device for the wiring harness according to claim 1, wherein the insulation enclosing module(60) comprises a second insulation docking shell(61) configured to accommodate the end of the to-be-detected wiring harness(10).

4. The insulation withstand voltage detection device for the wiring harness according to claim 1, wherein the conductive electrode plate (30) is configured on a bottom wall of the detection chamber(20).

5. An insulation withstand voltage detection method for a wiring harness, **characterized in that**, the method uses the insulation withstand voltage detection device according to any one of claims 1 to 4, and the method comprises:
step S10: placing a to-be-detected wiring harness (10) in the enclosed cavity (21) of the device, wherein a conductive electrode plate (30) is disposed in the enclosed cavity (21), and the to-be-detected wiring harness (10) has one end insulated and enclosed, and the other end connected to a power supply (41);
step S20: reducing air pressure in the enclosed cavity (21);
step S30: providing a test voltage by the power supply (41); and
step S40: detecting a voltage of the to-be-detected wiring harness (10), and/or detecting a leakage current of the to-be-detected wiring harness (10).

6. The insulation withstand voltage detection method for the wiring harness according to claim 5, wherein in the step S20, the air pressure in the enclosed cavity (21) is decreased to a vacuum degree of 0 mbar to 5,000 mbar.

7. The insulation withstand voltage detection method for the wiring harness according to claim 5, wherein a detection value of the voltage is compared with a set requirement value, a detection value of the leakage current is compared with a set requirement value, and when the detection value of the voltage and the detection value of the leakage current both meet requirements, it is judged that the insulation withstand voltage performance of the to-be-detected wiring harness (10) is qualified.

8. An automobile wiring harness assembly line, comprising the insulation withstand voltage detection device for the wiring harness according to any one of claims 1 to 4.

## Patentansprüche

1. Vorrichtung zum Detektieren einer Isolationsspannungsfestigkeit für einen Kabelbaum, umfassend:
eine Detektionskammer (20). die mit einem geschlossenen Hohlraum (21) versehen ist, in dem eine leitfähige Elektrodenplatte (30) angeordnet ist;
eine Vakuumvorrichtung (80), die mit dem geschlossenen Hohlraum (21) in Verbindung steht;
eine Stromversorgung (41), die elektrisch mit der leitfähigen Elektrodenplatte (30) verbunden ist;
ein leitfähiges Modul (50), dessen erstes Ende elektrisch mit der Stromversorgung (41) verbunden ist und dessen zweites Ende mit einem zu detektierenden Kabelbaum (10) verbunden ist und sich in dem geschlossenen Hohlraum (21) befindet; und
einen Stromdetektionssensor (71) und/oder einen Spannungsdetektionssensor (72), wobei der Stromdetektionssensor (71) in Reihe zwischen der Stromversorgung (41) und dem leitfähigen Modul (50) geschaltet ist und der Spannungsdetektionssensor (72) verwendet wird, um parallel zum zu detektierenden Kabelbaum (10) geschaltet zu sein;
wobei das leitfähige Modul (50) eine erste Isolier-Andockhülle (51) und einen darin angeordneten leitfähigen Kern (52) umfasst; und die erste Isolier-Andockhülle (51) so konfiguriert ist, dass sie ein Ende des zu detektierenden Kabelbaums (10) aufnehmen kann, und der leitfähige Kern (52) mit einem leitfähigen Anschluss (11) des zu detektierenden Kabelbaums (10) in Kontakt steht;
wobei die erste Isolier-Andockhülle (51) mit einem Aufnahmeraum (511) und einer in der Bodenwand des Aufnahmeraums (511) angeordneten Hüllendurchführungsöffnung (512) versehen ist;
der Aufnahmeraum (511) so konfiguriert ist, dass er das Ende des zu detektierenden Kabelbaums (10) aufnimmt, und der leitfähige Kern (52) in die Hüllendurchführungsöffnung (512) eingeführt wird und zumindest teilweise in den Aufnahmeraum (511) hineinragt; und
**dadurch gekennzeichnet, dass** eine Innenwand des Aufnahmeraums (511) mit einer Seitenwand eines Endes des zu detektierenden Kabelbaums (10) versehen ist und das Ende des zu detektierenden Kabelbaums (10) im Aufnahmeraum (511) durch einen Widerstand fixiert ist, der durch gegenseitiges Pressen zwischen der Innenwand des Aufnahmeraums (511) und dem Ende des zu detektierenden Kabelbaums (10) erzeugt wird; und
die Vorrichtung ferner ein Isolationsumhüllungsmodul (60) umfasst, das so konfiguriert ist, dass es das andere Ende des zu detektierenden Kabelbaums (10) isoliert und umschließt.

2. Vorrichtung zum Detektieren einer Isolationsspannungsfestigkeit für den Kabelbaum nach Anspruch 1, wobei der leitfähige Kern (52) über ein Stromkabel (42) mit der Stromversorgung (41) verbunden ist, ein Dichtungselement (24) mit dem Stromkabel (42) verbunden ist, die erste Isolier-Andockhülle (51) innerhalb einer Seitenwand der Detektionskammer (20) angeordnet ist und das Dichtungselement (24) mit einer Außenseite der Seitenwand der Detektionskammer (20) verbunden ist.

3. Vorrichtung zum Detektieren einer Isolationsspannungsfestigkeit für den Kabelbaum nach Anspruch 1, wobei das Isolationsumhüllungsmodul (60) eine zweite Isolier-Andockhülle (61) umfasst, die so konfiguriert ist, dass sie das Ende des zu detektierenden Kabelbaums (10) aufnimmt.

4. Vorrichtung zum Detektieren einer Isolationsspannungsfestigkeit für den Kabelbaum nach Anspruch 1, wobei die leitfähige Elektrodenplatte (30) an einer Bodenwand der Detektionskammer (20) konfiguriert ist.

5. Verfahren zum Detektieren einer Isolationsspannungsfestigkeit eines Kabelbaums, **dadurch gekennzeichnet, dass** das Verfahren die Vorrichtung zum Detektieren einer Isolationsspannungsfestigkeit nach einem der Ansprüche 1 bis 4 verwendet, wobei das Verfahren umfasst:
Schritt S10: Platzieren eines zu detektierenden Kabelbaums (10) in dem geschlossenen Hohlraum (21) der Vorrichtung, wobei in dem geschlossenen Hohlraum (21) eine leitfähige Elektrodenplatte (30) angeordnet ist und der zu detektierende Kabelbaum (10) an einem Ende isoliert und umschlossen ist und das andere Ende mit einer Stromversorgung (41) verbunden ist;
Schritt S20: Reduzieren eines Luftdrucks im geschlossenen Hohlraum (21);
Schritt S30: Bereitstellen einer Testspannung durch die Stromversorgung (41); und
Schritt S40: Detektieren einer Spannung des zu detektierenden Kabelbaums (10) und/oder Detektieren eines Leckstroms des zu detektierenden Kabelbaums (10).

6. Verfahren zum Detektieren einer Isolationsspannungsfestigkeit für den Kabelbaum nach Anspruch 5, wobei im Schritt S20 der Luftdruck im geschlossenen Hohlraum (21) auf einen Vakuumgrad von 0 mbar bis 5.000 mbar gesenkt wird.

7. Verfahren zum Detektieren einer Isolationsspannungsfestigkeit für den Kabelbaum nach Anspruch 5, wobei ein Detektionswert der Spannung mit einem festgelegten Anforderungswert verglichen wird, ein Detektionswert des Leckstroms mit einem festgelegten Anforderungswert verglichen wird und wenn sowohl der Detektionswert der Spannung als auch der Detektionswert des Leckstroms die Anforderungen erfüllen, davon ausgegangen wird, dass die Isolationsspannungsfestigkeitsleistung des zu detektierenden Kabelbaums (10) qualifiziert ist.

8. Montagelinie für Automobilkabelbäume, umfassend die Vorrichtung zum Detektieren einer Isolationsspannungsfestigkeit für den Kabelbaum nach einem der Ansprüche 1 bis 4.

## Revendications

1. Dispositif de détection de tension de tenue d'isolation pour faisceau de câbles, comprenant :
une chambre de détection (20) pourvue d'une cavité confinée (21) dans laquelle est disposée une plaque d'électrode conductrice (30) ;
un dispositif à vide (80) en communication avec la cavité confinée (21) ;
une alimentation électrique (41) reliée électriquement à la plaque d'électrode conductrice (30) ;
un module conducteur (50), dont une première extrémité est reliée électriquement à l'alimentation électrique (41), et dont une seconde extrémité est reliée à un faisceau de câbles à détecter (10) et située dans la cavité confinée (21) ; et
un capteur de détection de courant (71) et/ou un capteur de détection de tension (72), dans lequel le capteur de détection de courant (71) est relié en série entre l'alimentation électrique (41) et le module conducteur (50), et le capteur de détection de tension (72) est utilisé de façon à être relié en parallèle au faisceau de câbles à détecter (10) ;
dans lequel le module conducteur (50) comprend une première coque de maintien d'isolation (51) et une âme conductrice (52) disposée à l'intérieur; et la première coque de maintien d'isolation (51) est configurée pour recevoir une extrémité du faisceau de câbles à détecter (10), et l'âme conductrice (52) est en contact avec une borne conductrice (11) du faisceau de câbles à détecter (10) ;
dans lequel la première coque de maintien d'isolation (51) est pourvue d'une cavité de réception (511), et d'un trou traversant de coque (512) disposé sur une paroi inférieure de la cavité de réception (511) ;
la cavité de réception (511) est configurée pour recevoir l'extrémité du faisceau de câbles à détecter (10), et l'âme conductrice (52) est insérée dans le trou traversant de coque (512) et s'étend au moins partiellement dans la cavité de réception (511) ; et
**caractérisé en ce qu'**une paroi interne de la cavité de réception (511) est pourvue d'une paroi latérale d'une extrémité du faisceau de câbles à détecter (10), et l'extrémité du faisceau de câbles à détecter (10) est fixée dans la cavité de réception (511) par une résistance générée par une pression mutuelle entre la paroi interne de la cavité de réception (511) et l'extrémité du faisceau de câbles à détecter (10) ; et
le dispositif comprend en outre un module de confinement d'isolation (60) configuré pour isoler et confiner l'autre extrémité du faisceau de câbles à détecter (10).

2. Dispositif de détection de tension de tenue d'isolation pour faisceau de câbles selon la revendication 1, dans lequel l'âme conductrice (52) est reliée à l'alimentation électrique (41) par l'intermédiaire d'un câble électrique (42), un élément d'étanchéité (24) est relié au câble électrique (42), la première coque de maintien d'isolation (51) est disposée à l'intérieur d'une paroi latérale de la chambre de détection (20), et l'élément d'étanchéité (24) est relié à un côté externe de la paroi latérale de la chambre de détection (20).

3. Dispositif de détection de tension de tenue d'isolation pour faisceau de câbles selon la revendication 1, dans lequel le module de confinement d'isolation (60) comprend une seconde coque de maintien d'isolation (61) configurée pour recevoir l'extrémité du faisceau de câbles à détecter (10).

4. Dispositif de détection de tension de tenue d'isolation pour faisceau de câbles selon la revendication 1, dans lequel la plaque d'électrode conductrice (30) est configurée sur une paroi inférieure de la chambre de détection (20).

5. Procédé de détection de tension de tenue d'isolation pour faisceau de câbles, **caractérisé en ce que** le procédé utilise le dispositif de détection de tension de tenue d'isolation selon l'une quelconque des revendications 1 à 4, et le procédé comprend :
une étape S10 : placer un faisceau de câbles à détecter (10) dans la cavité confinée (21) du dispositif, dans lequel une plaque d'électrode conductrice (30) est disposée dans la cavité confinée (21), et le faisceau de câbles à détecter (10) présente une extrémité isolée et confinée, et l'autre extrémité reliée à une alimentation électrique (41) ;
une étape S20 : réduire une pression d'air dans la cavité confinée (21) ;
une étape S30 : délivrer une tension de test au moyen de l'alimentation électrique (41) ; et
une étape S40 : détecter une tension du faisceau de câbles à détecter (10), et/ou détecter un courant de fuite du faisceau de câbles à détecter (10).

6. Procédé de détection de tension de tenue d'isolation pour faisceau de câbles selon la revendication 5, dans lequel, à l'étape S20, la pression d'air dans la cavité confinée (21) est diminuée jusqu'à un degré de vide de 0 mbar à 5 000 mbar.

7. Procédé de détection de tension de tenue d'isolation pour faisceau de câbles selon la revendication 5, dans lequel une valeur de détection de la tension est comparée à une valeur d'exigence définie, une valeur de détection du courant de fuite est comparée à une valeur d'exigence définie, et lorsque la valeur de détection de la tension et la valeur de détection du courant de fuite répondent toutes deux aux exigences, il est évalué que les performances de tension de tenue d'isolation du faisceau de câbles à détecter (10) sont validées.

8. Chaîne de montage de faisceaux de câbles automobiles, comprenant le dispositif de détection de tension de tenue d'isolation pour faisceau de câbles selon l'une quelconque des revendications 1 à 4.
